# DEMANDE DE BREVET EUROPEEN

(11) **EP 4 683 447 A1**
(43) Date de publication de la demande: **21.01.2026**
(21) Numéro de dépôt: 25189606.4
(22) Date de dépôt: 15.07.2025
(51) Int. Cl.: H05K 7/20

(54) **EQUIPEMENT À ÉCRÊTAGE THERMIQUE PAR MATÉRIAU À CHANGEMENT DE PHASE**

(30) Priorité: 15.07.2024 FR 2407722
(71) Demandeur: THALES, 92190 Meudon (FR)
(72) Inventeur: BORRAT-MICHAUD, Pierre, 49309 CHOLET (FR); CHUPIN, Edouard, Alain, Sébastien, 49309 CHOLET (FR); PELET, Sébastien, Mickaël, Jérôme, 49309 CHOLET (FR)
(74) Mandataire: Lavoix

(57) **Abrégé**

L'équipement (10) comprend :
- un compartiment principal (20) comportant au moins un système électronique (22) apte à générer de l'énergie thermique ;
- un échangeur thermique (40) en communication aéraulique avec le compartiment principal (20), apte à transférer l'énergie thermique générée par l'au moins un système électronique (22) à l'extérieur de l'équipement (10) ;
- un compartiment auxiliaire (60) en communication aéraulique avec le compartiment principal (20) et l'échangeur de chaleur (40) et comportant au moins un bloc d'absorption thermique (72) comprenant un matériau à changement de phase et étant configuré pour absorber l'énergie thermique générée par l'au moins un système électronique (22).

## Description

La présente invention concerne un équipement, dans lequel notamment la thermique d'au moins un système électronique est gérée.

Un tel équipement est, par exemple, destiné à être utilisé dans un environnement sévère, du type désertique, dans lequel ledit équipement est soumis des variations de température extérieure importantes et est susceptible de subir des intrusions de sable et poussières.

Des températures importantes peuvent mener à une surchauffe des composants électroniques de l'équipement. La surchauffe des composants réduit le temps moyen entre pannes (ou « *mean time between failures* » en anglais).

Pour pallier à cet inconvénient, il est connu d'assurer un refroidissement actif des composants électroniques, notamment par ventilation en amenant de l'air extérieur au contact desdits composants ou par une climatisation exploitant un fluide frigorigène.

Toutefois, ces solutions mènent à l'intrusion de sable et poussière, ce qui présente également des risques d'endommager les composants électroniques, ou à une surconsommation d'énergie.

Il existe donc un besoin pour un équipement permettant un refroidissement amélioré des composants électroniques tout en réduisant les risques de panne de l'équipement et en réduisant la consommation d'énergie.

Le but de l'invention est alors de proposer un équipement permettant d'augmenter le temps moyen entre pannes, notamment en permettant une stabilisation thermique de l'électronique tout en évitant l'intrusion de corps étrangers et en réduisant la consommation d'énergie.

A cet effet, l'invention a pour objet un équipement comprenant :
- un compartiment principal comportant au moins un système électronique apte à générer de l'énergie thermique ;
- un échangeur thermique en communication aéraulique avec le compartiment principal, apte à transférer l'énergie thermique générée par l'au moins un système électronique à l'extérieur de l'équipement ;
- un compartiment auxiliaire en communication aéraulique avec le compartiment principal et l'échangeur de chaleur et comportant au moins un bloc d'absorption thermique comprenant un matériau à changement de phase et étant configuré pour absorber l'énergie thermique générée par l'au moins un système électronique.

Grâce à l'invention, un écrêtage thermique du système électronique est possible sans nécessiter d'apport d'air extérieur. Il est en outre évité de recourir à un climatiseur ce qui réduit la consomation d'énergie de l'équipement

Suivant d'autres aspects avantageux de l'invention, l'équipement comprend une ou plusieurs des caractéristiques suivantes, prises isolément ou suivant toutes les combinaisons techniquement possibles :
- l'équipement comprend en outre au moins un ventilateur configuré pour faire circuler l'air entre le compartiment principal, l'échangeur thermique et le compartiment auxiliaire ;
- le compartiment principal, l'échangeur thermique et le compartiment auxiliaire forment un ensemble hermétique d'indice de protection IP65 selon la norme IEC 60529 ;
- au moins le compartiment auxiliaire est recouvert au moins partiellement d'un matériau thermiquement isolant dont la conductivité thermique est comprise entre 0,025 W/mK et 0,05 W/mK ;
- le compartiment auxiliaire s'étend selon une direction longitudinale entre une entrée et une sortie, l'au moins un bloc d'absorption thermique s'étendant dans un plan d'extension sensiblement perpendiculaire à la direction longitudinale ;
- le compartiment auxiliaire comprend une pluralité de blocs d'absorption thermique agencés en quinconce selon la direction longitudinale de sorte à former un passage de circulation d'air en chicanes entre l'entrée et la sortie du compartiment auxiliaire ;
- le matériau à changement de phase a une température de fusion comprise entre 40°C et 50°C, de préférence entre 42°C et 46°C, notamment sensiblement égale à 44°C ;
- l'équipement comprend en outre au moins un module de refroidissement thermoélectrique configuré pour refroidir l'au moins un bloc d'absorption thermique ;
- l'au moins un module de refroidissement thermoélectrique comprend une portion d'absorption d'énergie thermique et une portion de libération d'énergie thermique, la portion d'absorption d'énergie thermique s'étendant dans l'au moins un bloc d'absorption thermique et la portion de libération d'énergie thermique s'étendant en dehors du compartiment auxiliaire

L'invention apparaîtra plus clairement à la lecture de la description qui va suivre, donnée uniquement à titre d'exemple non limitatif, et faite en référence aux dessins dans lesquels :
[Fig. 1] - la figure 1 est une illustration schématique simplifié d'un équipement selon l'invention ;
[Fig. 2] - la figure 2 est un graphe illustrant l'évolution de la température de l'air en sortie de l'échangeur thermique de l'équipement de la figure 1 et de la température de l'air en sortie de compartiment auxiliaire de l'équipement de la figure 1 lorsque l'équipement est soumis à une évolution de température extérieur selon le cycle A1 défini par la norme STANAG 4370, en fonction de l'heure de la journée.

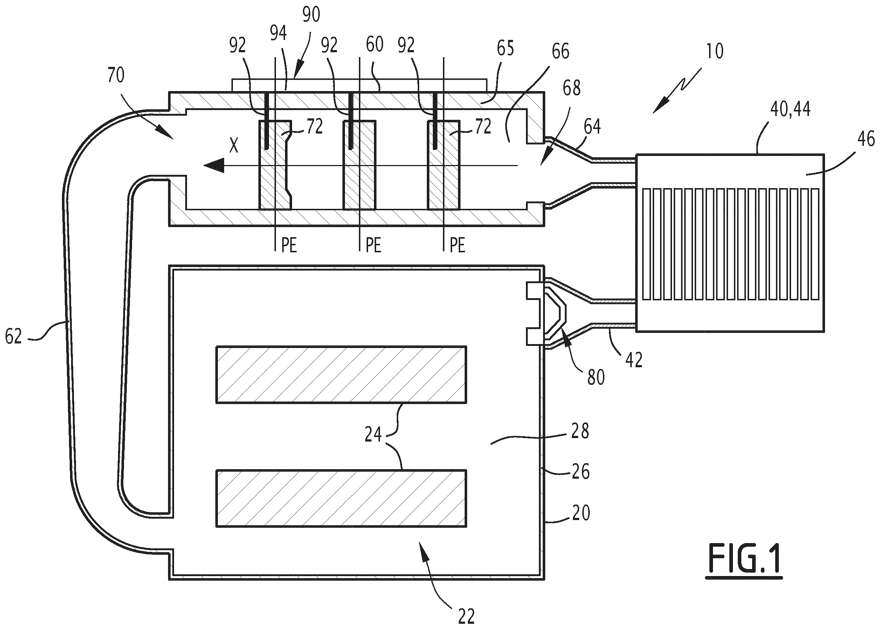

En référence à la figure 1, on décrit un équipement 10 selon l'invention.

L'équipement 10 est notamment destiné à être utilisé dans un environnement sévère, tel qu'un désert, et est en particulier transportable.

L'équipement 10 comprend un compartiment principal 20, un échangeur thermique 40 et un compartiment auxiliaire 60.

Avantageusement, le compartiment principal 20, l'échangeur thermique 40 et le compartiment auxiliaire 60 forment un ensemble hermétique par exemple d'indice de protection IP65 selon la norme IEC 60529. En d'autres termes, le compartiment principal 20, l'échangeur thermique 40 et le compartiment auxiliaire 60 forment un ensemble étanche aux corps solides et aux corps liquides externes audit ensemble.

Encore avantageusement, l'équipement 10 comprend en outre au moins un ventilateur 80.

Encore avantageusement, l'équipement 10 comprend en outre au moins un module de refroidissement thermoélectrique 90.

Le compartiment principal 20 comporte au moins un système électronique 22 apte à générer de l'énergie thermique.

Par exemple, l'au moins un système électronique 22 comprend au moins un composant électronique 24, tel que par exemple des interrupteurs, des serveurs, des routeurs, des pares-feu, des alimentations (notamment sans interruption). L'au moins un composant électronique 24 est notamment un produit informatique standard ou produit informatique COTS (de l'anglais « *commercial off-the-shelf* »).

Dans l'exemple de la figure 1, l'au moins un système électronique 22 comprend deux composants électroniques 24.

L'au moins un système électronique 22 est notamment agencé dans une enceinte 26 du compartiment principal 20, délimitant un espace 28 de réception dans lequel s'étend l'au moins un système électronique 22.

L'échangeur thermique 40 est apte à transférer l'énergie thermique générée par l'au moins un système électronique 22 à l'extérieur de l'équipement 10.

L'échangeur thermique 40 est en communication aéraulique avec le compartiment principal 20, en particulier par l'intermédiaire d'au moins une conduite 42 de l'équipement.

Notamment, l'échangeur thermique 40 est délimité par une enceinte 44 délimitant un volume intérieur 46, ledit volume intérieur 46 étant en communication fluidique avec l'espace de réception 28 du compartiment principal 20, en particulier par l'intermédiaire de la conduite 42.

Le compartiment auxiliaire 60 est en communication aéraulique avec le compartiment principal 20, notamment par l'intermédiaire d'au moins une conduite 62 et l'échangeur de chaleur 40, notamment par l'intermédiaire d'au moins une conduite 64.

Avantageusement, le compartiment auxiliaire 60 est délimité par une enceinte 65 délimitant un espace intérieur 66.

Encore avantageusement, le compartiment auxiliaire 60 s'étend selon une direction longitudinale X entre une entrée 68 et une sortie 70. Notamment, l'entrée 68 et la sortie 70 forment une entrée 68 et une sortie 70 de l'espace intérieur 66.

Au moins le compartiment auxiliaire 60 est recouvert au moins partiellement d'un matériau thermiquement isolant dont la conductivité thermique est comprise entre 0,025 W/mK et 0,05 W/mK. Par exemple, au moins le compartiment auxiliaire 60 et la conduite 62 sont recouverts du matériau thermiquement isolant.

Le compartiment auxiliaire 60 comporte au moins un bloc 72 d'absorption thermique.

Avantageusement, le compartiment auxiliaire 60 comprend une pluralité de blocs d'absorption thermique 72. Selon l'exemple spécifique de la figure 1, le compartiment auxiliaire 60 comporte trois blocs 72 d'absorption thermique agencés les uns derrière les autres selon la direction longitudinale X.

L'au moins un bloc d'absorption thermique 72 est configuré pour absorber l'énergie thermique générée par l'au moins un système électronique 22.

L'au moins un bloc d'absorption thermique 72 comprend un matériau à changement de phase.

Selon l'exemple spécifique de la figure 1, l'au moins un bloc d'absorption thermique 72 s'étend dans un plan d'extension PE sensiblement perpendiculaire à la direction longitudinale X.

Avantageusement, lorsque le compartiment auxiliaire 60 comprend une pluralité de blocs d'absorption thermique 72, les blocs 72 sont agencés en quinconce selon la direction longitudinale X, de sorte à former un passage de circulation d'air en chicanes entre l'entrée 68 et la sortie 70 du compartiment auxiliaire 60.

Par exemple, le matériau à changement de phase a une température de fusion comprise entre 40°C et 50°C, de préférence entre 42°C et 46°C, notamment sensiblement égale à 44°C. Ces caractéristiques permettent de respecter le cycle A1 de la norme STANAG 4370 dans l'exemple de la figure 1. Suivant d'autres normes et/ou d'autres conditions (nombre de composants électroniques 24 par exemple), l'homme du métier saurait choisir un matériau à changement de phase avec une température de fusion adéquate.

Selon un exemple spécifique, le matériau à changement de phase est du RUBITHERM^{®} RT44HC.

L'au moins un ventilateur 80 est configuré pour faire circuler l'air entre le compartiment principal 20, l'échangeur thermique 40 et le compartiment auxiliaire 60.

Dans l'exemple spécifique de la figure 1, l'au moins un ventilateur 80 est agencé en entrée de la conduite 42.

L'au moins un module de refroidissement thermoélectrique 90 est configuré pour refroidir l'au moins un bloc d'absorption thermique 72.

Avantageusement, lorsqu'il est mis en œuvre, l'au moins un module de refroidissement thermoélectrique 90 comprend une portion d'absorption d'énergie thermique 92 et une portion de libération d'énergie thermique 94.

La portion d'absorption d'énergie thermique 92 s'étend dans l'au moins un bloc d'absorption thermique 72 et la portion de libération d'énergie thermique 94 s'étend en dehors du compartiment auxiliaire 60, notamment en dehors de l'enceinte 65 dans l'atmosphère environnant le compartiment auxiliaire 60.

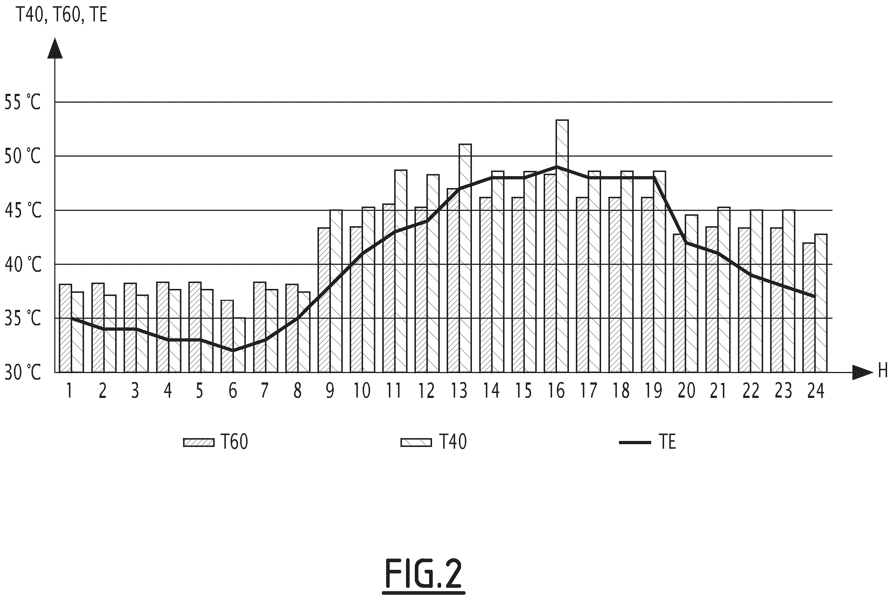

La figure 2 illustre l'évolution de la température T40 de l'air en sortie de l'échangeur thermique 40 de l'équipement 10 et de la température T60 de l'air en sortie de compartiment auxiliaire 60 de l'équipement 10 lorsque l'équipement 10 est soumis à une évolution de température extérieur TE selon le cycle A1 défini par la norme STANAG 4370 en fonction de l'heure H de la journée.

Dans cet exemple :
- le matériau à changement de phase a une température de fusion sensiblement égale à 43°C ;
- l'au moins un système électronique 22 présente une puissance d'émission thermique de 180 W ;
- le compartiment auxiliaire 60 comporte 50 L de matériau à changement de phase.

Dans la figure 2, on observe :
- entre 0h et 8h, la température T40 de l'air en sortie de l'échangeur thermique 40 de l'équipement 10 est inférieure à la température T60 de l'air en sortie de compartiment auxiliaire 60 de l'équipement 10 ;
- entre 9h et 24h, la température T40 de l'air en sortie de l'échangeur thermique 40 de l'équipement 10 est supérieure à la température T60 de l'air en sortie de compartiment auxiliaire 60 de l'équipement 10.

La figure 2 montre donc :
- entre 0h et 8h, un réchauffement de l'air circulant depuis l'échangeur thermique 40 vers le compartiment principal 20, ce qui montre une libération d'énergie thermique de la part de l'au moins un bloc d'absorption thermique 72, ce qui correspond à une solidification du matériau à changement de phase ;
- entre 9h et 24h, un refroidissement de l'air circulant depuis l'échangeur thermique 40 vers le compartiment principal 20, ce qui montre une absorption d'énergie thermique de la part de l'au moins un bloc d'absorption thermique 72, ce qui correspond à une fusion du matériau à changement de phase.

Entre 0h et 8h, la température extérieure est inférieure à 35°C. Les besoins de refroidissement de l'au moins un système électronique 22 sont moindres, ce qui permet de procéder à une solidification du matériau à changement de phase, afin de préparer la période plus chaude de 8h à 24h.

Entre 8h et 24h, la température extérieure est entre 35°C et 49°C. Les besoins de refroidissement de l'au moins un système électronique 22 sont alors élevés, et la fusion du matériau à changement de phase permet d'absorber une portion de l'énergie thermique générée par l'au moins un système électronique 22.

Avantageusement, le ratio absorption/régénération est supérieur à 2,7. Ce ratio correspond au rapport d'énergie thermique absorbée le jour sur l'énergie thermique libérée la nuit.

Grâce à l'invention, une régulation thermique du système électronique 22 est permise tout en évitant l'intrusion de corps étrangers à l'intérieur de l'équipement 10. En outre, il est évité d'avoir recours à un refroidissement actif par climatisation, ce qui réduit considérablement la consommation d'énergie de l'équipement 10. Ainsi, les risques de panne dûs à la surchauffe mais également ceux liés à l'intrusion de corps étranger de type sable et poussières, sont réduits. Le temps moyen entre pannes est réduit.

## Revendications

1. Equipement (10) comprenant :
- un compartiment principal (20) comportant au moins un système électronique (22) apte à générer de l'énergie thermique ;
- un échangeur thermique (40) en communication aéraulique avec le compartiment principal (20), apte à transférer l'énergie thermique générée par l'au moins un système électronique (22) à l'extérieur de l'équipement (10) ;
- un compartiment auxiliaire (60) en communication aéraulique avec le compartiment principal (20) et l'échangeur de chaleur (40) et comportant au moins un bloc d'absorption thermique (72) comprenant un matériau à changement de phase et étant configuré pour absorber l'énergie thermique générée par l'au moins un système électronique (22).

2. Equipement (10) selon la revendication 1, dans lequel l'équipement (10) comprend en outre au moins un ventilateur (80) configuré pour faire circuler l'air entre le compartiment principal (20), l'échangeur thermique (40) et le compartiment auxiliaire (60).

3. Equipement (10) selon la revendication 1 ou 2, dans lequel le compartiment principal (20), l'échangeur thermique (40) et le compartiment auxiliaire (60) forment un ensemble hermétique d'indice de protection IP65 selon la norme IEC 60529.

4. Equipement (10) selon l'une quelconque des revendications précédentes, dans lequel au moins le compartiment auxiliaire (60) est recouvert au moins partiellement d'un matériau thermiquement isolant dont la conductivité thermique est comprise entre 0,025 W/mK et 0,05 W/mK.

5. Equipement (10) selon l'une quelconque des revendications précédentes, dans lequel le compartiment auxiliaire (60) s'étend selon une direction longitudinale (X) entre une entrée (68) et une sortie (70), l'au moins un bloc d'absorption thermique (72) s'étendant dans un plan d'extension (PE) sensiblement perpendiculaire à la direction longitudinale (X).

6. Equipement (10) selon la revendication 5, dans lequel le compartiment auxiliaire (60) comprend une pluralité de blocs d'absorption thermique (72) agencés en quinconce selon la direction longitudinale (X) de sorte à former un passage de circulation d'air en chicanes entre l'entrée (68) et la sortie (70) du compartiment auxiliaire (60).

7. Equipement (10) selon l'une quelconque des revendications précédentes, dans lequel le matériau à changement de phase a une température de fusion comprise entre 40°C et 50°C, de préférence entre 42°C et 46°C, notamment sensiblement égale à 44°C.

8. Equipement (10) selon l'une quelconque des revendications précédentes, dans lequel l'équipement (10) comprend en outre au moins un module de refroidissement thermoélectrique (90) configuré pour refroidir l'au moins un bloc d'absorption thermique (72).

9. Equipement (10) selon la revendication 8, dans lequel l'au moins un module de refroidissement thermoélectrique (90) comprend une portion d'absorption d'énergie thermique (92) et une portion de libération d'énergie thermique (94), la portion d'absorption d'énergie thermique (92) s'étendant dans l'au moins un bloc d'absorption thermique (72) et la portion de libération d'énergie thermique (94) s'étendant en dehors du compartiment auxiliaire (60).
